# EUROPEAN PATENT SPECIFICATION

(11) **EP 0 365 166 B1**
(45) Date of publication and mention of the grant of the patent: **23.02.1994**
(21) Application number: 89309980.4
(22) Date of filing: 29.09.1989
(51) Int. Cl.: C30B 25/18, H01L 21/20

(54) **Crystal article and method for forming same**
Gegenstand aus Kristall und Verfahren zu seiner Herstellung
Objet en cristal et procédé pour sa fabrication

(30) Priority: 02.10.1988 JP 247816/88; 29.09.1989 JP 255525/89
(43) Date of publication of application: 25.04.1990
(73) Proprietor: CANON KABUSHIKI KAISHA, Tokyo (JP)
(72) Inventor: Sato, Nobuhiko, Atsugi-shi Kanagawa-ken (JP)
(74) Representative: Beresford, Keith Denis Lewis

(56) References cited:
- EP-A- 0 284 437
- APPLIED PHYSICS LETTERS, volume 52, number 15, 11th April 1988, New York, NY, USA; T. TONCHARA et al.: "Manipulation of nucleation sites and periods over amphous substrates", pages 1231-1233
- JOURNAL OF CRYSTAL GROWTH, volumne 47, 1979, Amsterdam, NL; X. Gerbaux et al.: "Applicability of the epitaxial nucleation in submicroslopie holes (ENSH) method to vapour growth: Preparation of oriented thin films of Naphthalenc, durene, benzoic acid and tellurium", pages 593-597
- IDEM

## Description

This invention relates to a method of forming a crystalline film, particularly a crystalline film of semiconductor material having a plurality of single crystal grains formed on a deposition surface at predetermined positions with grain boundaries also formed at predetermined positions, the sizes of the single crystal grains being of a predetermined size.

The present invention is applicable to the production of crystalline film to be utilised in the production of, for example, electronic elements such as semiconductor integrated circuits, magnetic circuits, etc., optical elements, magnetic elements, piezoelectric elements, or surface acoustic elements, etc.

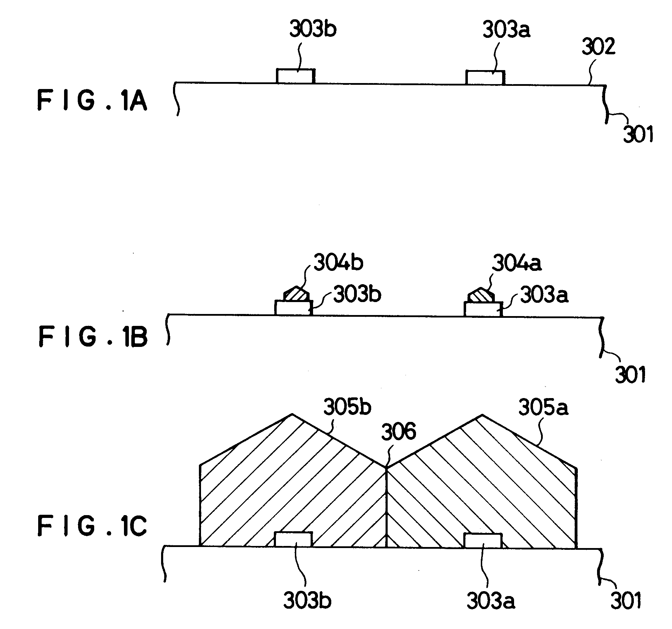

In the general field of semiconductor-on-insulator technology there has been proposed a method which is based on selective nucleation depending on the difference in nucleation density between the surface materials (T. Yonehara et al (1987). Extended Abstracts of the 19th Conference on Solid State Devices and Materials, Tokyo, 1987, pp. 191-194). The crystal formation method is to be described by referring to Figs. 1A-1C. First, as shown in Fig.1A, on a substrate 301 having a surface 302 with small nucleation density are arranged regions 303a, 303b having surfaces with sufficiently larger nucleation density than the surface 302 with a diameter of a and an interval b . If a predetermined crystal formation treatment is applied to the substrate, crystal nuclei of the deposited product will be generated only on the surfaces of the regions 303a, 303b, and never on the surface 302 (see Fig. 1B). Accordingly, the surfaces of the regions 303a, 303b are called nucleation surfaces (S_{NDL}) and the surface 302 non-nucleation surface (S_{NDS}). If the nuclei 304a, 304b generated on the nucleation surfaces 303a, 303b are further permitted to grow, they become single crystals 305a, 305b (see Fig. 1C), and grow onto the non-nucleation surface 302 beyond the regions of the nucleation surfaces 303a, until they contact single crystals 305b grown from adjacent nucleation surface sites 303b to form a grain boundary 306. In the crystal formation method of the prior art, there has been reported an example, in which the nucleation surfaces 303a, 303b are formed of amorphous silicon nitride Si₃N₄, the non-nucleation surface 302 is formed of Si0₂, and a plurality of Si single crystals are formed according to the CVD method (see the above paper), and an example, in which the non-nucleation surface is formed of Si0₂, the region which becomes the nucleation surface is formed by implanting Si ions into the non-nucleation surface with a focused ion beam, and subsequently a plurality of Si single crystals are formed according to the CVD method (The 35th Associated Lectures Related to Applied Physics, 1988, 28p-M-9, p.584, Abstract of a paper entitled "SENTAXY (Selective Nucleation Epitaxy) by FIB(2)" by H. Kumomi et al. (Japanese text).

However, when these single crystals are formed at lattice points according to a crystal formation method with controlled formation positions thereof, there may sometimes occur the problems described below, and in that case, problems may sometimes occur in forming a semiconductor integrated circuit or other electronic or optical element.

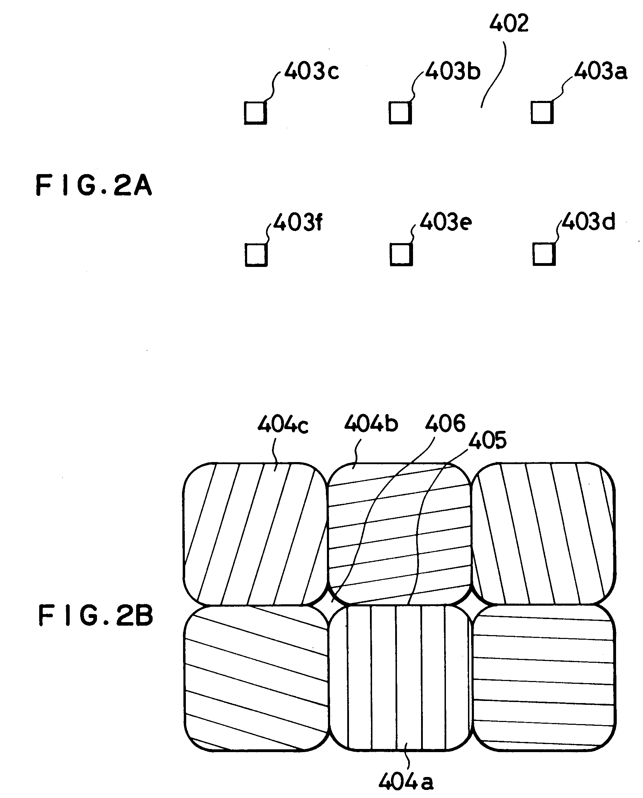

When the nucleation surfaces shown in Figs. 1A-1C are arranged at lattice points on the non-nucleation surface as shown in Fig. 2A, and the crystal growth treatment is applied thereto, for example, the single crystal 404b, grown from the nucleation surface 403b which is the nearest nucleation surface to the nucleation surface 403e, contacts the single crystal 404a to form a grain boundary 405. However, at the central portion at the interval from the second nearest nucleation surface 403c relative to the nucleation surface 403e, the single crystals do not completely contact each other, whereby a void 406 is left (see Fig. 2B). This void 406 may be apparently extinguished by close contact between the upper portions of the single crystals by increasing the crystal growth treatment time, but when the upper portions of the single crystals are removed by etching or polishing to produce a flat surface for forming a semiconductor integrated circuit, or other electronic or optical elements, etc., the void 406 can be exposed.

On the void 406, it is impossible to form an element utilising the characteristics of the single crystal such as MOS transistors, diodes, etc. Further, even when a thin film intended for wiring is formed over the void 406, since the film thickness of the crystal grain after flattening is some 10nm (100Å) or higher, generally about 1 µm, wire breaking can occur at the stepped difference portion between the non-nucleation surface 402 in the void 406 and the single crystals 404a, 404b, 404c.

Accordingly, when the surface portions of a plurality of single crystals, formed according to the crystal formation method in which these single crystals are formed with controlled positions thereof, are flattened by etching or polishing, and a semiconductor integrated circuit or other elements, etc. are formed thereon, since the active region is formed by avoiding the void 406, the circuit constitution or the element constitution is restricted to a lower degree of freedom in design, and problems can occur in miniaturisation of the element.

Applied Physics Letters, Vol.52, No.15, pp.1231 to 1233, 11th April 1988, New York, N.Y., U.S.A., T. Yonehara et al: "Manipulation of nucleation sites and periods over amorphous substrates" also describes Sentaxy deposition of silicon on regular spaced sites of silicon nitride nucleation material. The arrangement of the nucleation sites as shown in Fig. 1(c) of this reference is the same as that shown in Fig. 2(a) of the present drawings.

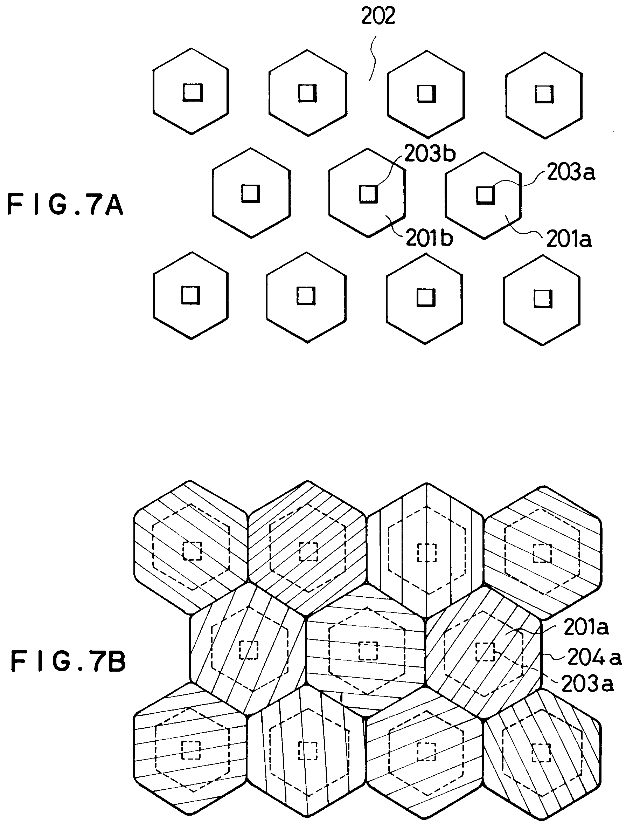

European Patent Application EP-A-0284437 describes the growth of crystalline film and/or single crystal islands of a III-V compound semiconductor material. Examples are described therein e.g. with reference to Figs. 7A and 7B where nucleation sites are formed on the non-nucleating surface of a substrate and semiconductor material is caused to nucleate on the sites and grow until single crystal grains come into contact forming a polycrystalline film. The nucleation sites are located a regular distance apart at the intersection points of a square lattice. Subsequently the grains of the crystalline film may be separated by etch processing. Alternatively, the nucleation sites may each be formed on the floor of a recess provided in the substrate surface, in which case the recesses can be filled by grown single crystal material and growth discontinued after recess filling but prior to overlayer growth.

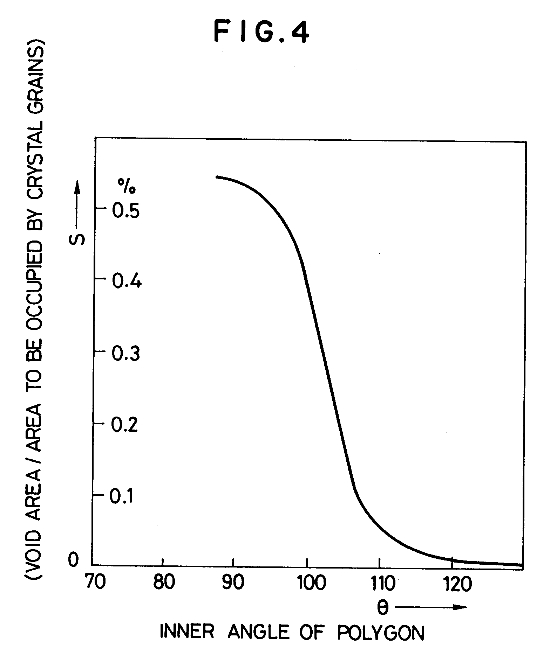

Journal of Crystal Growth, Vol.47, pp. 593-597, 1979 Amsterdam, Netherlands, Gerbaux et al; "Applicability of the Epitaxial Nucleation in Sub-Microscopic Holes" (ENSH) Method to Vapour Growth: Preparation of oriented thin films of naphthalene, durene, benzoic acid and tellurium" is also mentioned as an example of a method in which growth is initiated at predetermined sites. In one example described napthalene crystals are grown on silver film coated single crystal naphthalene. From the photomicrograph shown it is apparent that the napthalene crystals have an hexagonal growth habit in which their side facets are closely parallel. As shown in Fig. 1, however, the single crystal grains are of different size and do not appear to emanate from regularly spaced sites. Fig. 4 of this document also illustrates the growth of small parallel rod like single crystals of benzoic acid centred on holes in a Mylar film applied on a bulk single crystal made of benzoic acid. The holes are arranged a regular distance apart at the lattice points of a square lattice.

The present method is intended as a solution to the problem aforesaid.

In accordance with the present invention there is provided a method of forming a crystalline film of semiconductor material on the surface of a substrate which method comprises:
producing a multiplicity of crystal growth sites at the surface of said substrate;
growing a single crystal of said semiconductor material at each of said sites; and
continuing growth of each single crystal at least until each comes into contact with those growing adjacent thereto, thereby forming a crystalline film;
which method is characterised in that said producing of sites is performed such that said sites are regularly spaced and located at positions of 6-fold symmetry.

It is found here, as will be described in more detail below, that where the crystal growth sites are located at the lattice points of an hexagonal lattice i.e. at positions of 6-fold symmetry, there is a significant reduction in the proportion of total area occupied by void space. There is also a reduction in the area of each void. This therefore leads to a relaxation in design constraints and an improvement in yield.

The crystal growth sites may be formed directly upon the surface of the substrate or alternatively may be formed on the floor of concavities, i.e. recesses defined in the substrate surface. Where the growth sites are each provided on the floor of a respective concavity it is advantageous that the concavity should be of n-gonal cross-section where n is integer and not less than 5. In the latter case this also leads to reduction in the proportion of area occupied by void space.

In the accompanying drawings:
Figs. 1A-1C are schematic illustrations for explaining a method of forming a crystalline film according to the prior art;
Figs. 2A and 2B are schematic illustrations for explaining this method;
Figs. 3A-3C are illustrations showing one example of the shape of a concavity provided on a substrate;
Fig. 4 is a graph showing the relationship between the inner angle of a polygon and the ratio of area of void relative to the area to be occupied by crystalline material; and
Figs. 5 to Fig. 7 are illustrations for explanation of Examples of the present invention.

For a better understanding of the invention, preferred embodiments will be described hereinbelow and reference will be made to the drawings aforesaid. The following description is given by way of example only.

When a substrate surface is to be embedded with a plurality of single crystals, the average shape of the region occupied by each single crystal grain is a Wigner-Seitz cell formed when considering the nucleation surfaces as lattice points (the minimum section including the central lattice point constituted as surrounded by the perpendicular bisectors of the line segments with adjacent lattice points with one lattice point as the centre).

More specifically, for example, when the nucleation surfaces are arranged at 4-fold symmetrical positions, 5-fold symmetrical positions and 6-fold symmetrical positions, the shapes of the cell are tetragonal, pentagonal and hexagonal, respectively.

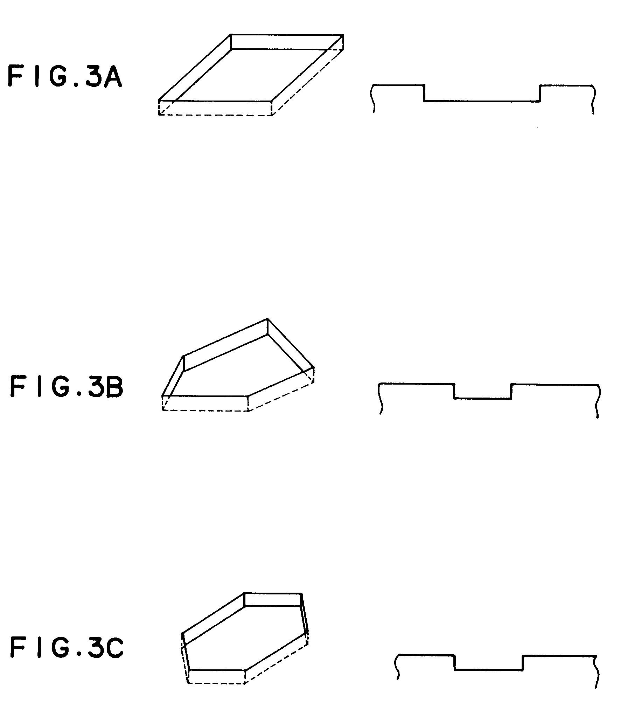

One aspect of the present invention is based on the discovery that, when nucleation surface is arranged at the centre of a concavity provided on the base material surface, and crystal growth step is applied with various sizes and shapes of the region where single crystal can grow in the lateral direction by working the shape seen from the upper surface of the concavity to many regular n-gonal (n ≧ 5) such as square, regular pentagonal, regular hexagonal, shapes as shown in Figs. 3A-3C, if the shape seen from the upper surface of the concavity is regular n-gonal (n ≧ 5) such as pentagonal, hexagonal, etc., or "circular" shape corresponding to the limiting state when n is made infinite, the ratio of void area can be reduced to one tenth or lower of the void area ratio when the shape of the concavity is square, to an extent which will pose no problem in practical application.

Also, the ratio of voids formed between crystals can be made smaller without any practical problem, even when nucleation surfaces are arranged on a flat base material surface without formation of concavity on the surface of the base material and selective growth is carried out, provided that the shape of the crystal grown is n-gonal (n ≧ 5) which is the shape of the Wigner-Seltz cell.

The crystal grown by the selective growth method can be controlled in its size, and the position of grain boundaries, and therefore the shape seen from the upper surface becomes substantially the Wigner-Seitz cell as described above.

Here, the ratio of the void area between the crystal as grown relative to the area to be occupied by the above cell (area to be occupied by crystals) versus inner angle of the polygon is shown in Fig. 4.

As can be seen also from Fig. 4, it can be understood that the area of void will be abruptly reduced at about an inner angle of the polygon exceeding 100°.

By applying crystal formation treatment to a substrate and controlling the shape of the region to be occupied with single crystals as described above in order to prevent generation of voids between a plurality of single crystals on the substrate, the size of void will become dramatically smaller as compared with the prior art, whereby there is substantially no problem such as wire breaking, etc. during wiring, etc.

Since a flat group of single crystal grains without stepped difference formed by single crystal grains in contact at grain boundaries can be obtained, in addition to formation of active elements such as transistors, etc. on the single crystal grains, it is also possible to effect further and higher integration by forming passive elements such as capacitors, resistances etc. at regions across the grain boundaries.

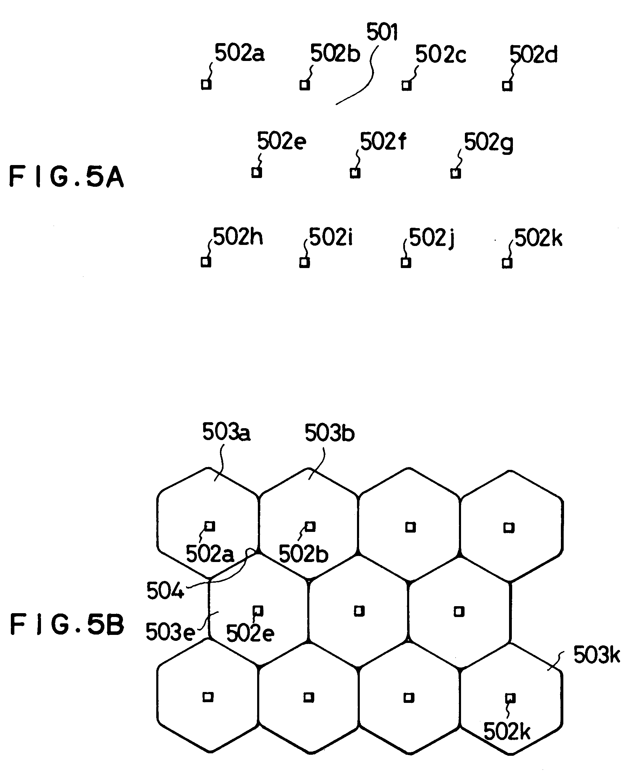

Refer now to Fig. 5 to Fig. 7. On a substrate, the treatment necessary for controlling the positions for formation of the crystals is applied. This method may be also practiced by, for example, arranging a non-nucleation surface and a plurality of nucleation surfaces each having an area sufficiently small to result in the formation of only one nucleus from which a single crystal is grown and having greater nucleation density than the non-nucleation surface at desired positions on a substrate.

Here, the nucleation density of the nucleation surface should preferably be greater by at least 10²-fold, more preferably by at least 10³-fold than that of the non-nucleation surface.

Alternatively, there may also be employed a method in which a non-nucleation surface is arranged on a substrate, and fine single crystals are arranged in a plural number at desired positions on the non-nucleation surface. Other methods too can be adopted.

As described above, when a concavity is formed on a substrate and a single crystal is formed there, the shape of the concavity seen from the upper surface is made n-gonal (n ≧ 5, more desirably n ≧ 6), or a shape having a curve such as an ellipse, circle, etc. In particular since also the substrate surface is provided with a plurality of single crystals either with or without prior formation of any concavities, the average shape of the region occupied by each single crystal, namely the shape of Wigner-Seitz cell is made regular hexagonal, a honeycomb structure is obtained, and single crystal grains are juxtaposed on the substrate efficiently with a smaller size of void.

Figs. 5A and 5B show schematically an example of the method for forming a crystal article when the shape of Wigner-Seitz cell is made regular hexagonal. Fig. 5A is a view of the substrate having nucleation surfaces 502a...502k arranged on the non-nucleation surface 501 seen from the upper surface.

By applying as the crystal growth treatment a gas phase growth method such as thermal CVD, plasma CVD, optical CVD, sputtering, etc., and a liquid phase growth method such as the gradual cooling method, the temperature gradient method, etc., the crystals 503a...503k will grow selectively with the nucleation surfaces 502a...502k as the origination points for crystal growth.

The area of the void 504 between the crystal 503a, 503b, 503e formed at this time will become very much smaller relative to that area occupied by the crystal grains.

The reason why the shape of the concavity provided on the substrate surface as described above is made n-gonal (n ≧ 5) or a shape having a curve such as circular is because the value of (area of one void/area to be occupied by single crystal) is abruptly reduced immediately before n is over 5 and the inner angle is over 108°. This may be considered to be due to the fact that the shape to be occupied by single crystal approaches the usual shape of a faceted single crystal.

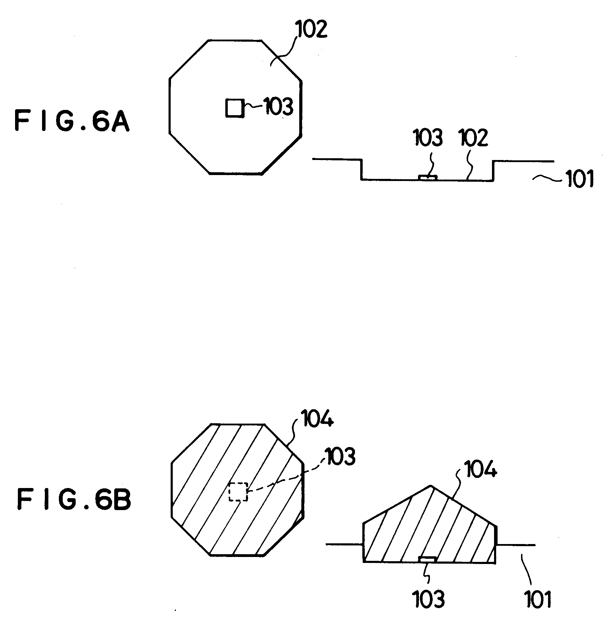

Figs. 6A and 6B show an example of a method of forming crystalline film when the concavity shape is regular octagonal.

101 is a substrate, and on the substrate 101 is provided a concavity having a regular octagonal planar shape and a non-nucleation surface 102, and at its centre is provided a nucleation surface 103 which is to become the origination point for crystal growth. When the substrate applied with such working treatment is exposed to crystal growth treatment according to a gas phase method such as a CVD method or a liquid phase method under predetermined conditions for a predetermined time, a single crystal grain 104, with a contact surface with the substrate of approximately regular octagonal shape, will grow as shown in Fig.6B.

Figs. 7A and 7B show an example of a case when a plurality of single crystal grains are formed. At predetermined positions of the substrate 202, first a plurality of concavities 201a, 201b... with regular hexagonal base shape are provided to desired depths. For the floor of each of the concavities 201a, 201b, and that portion other than the concavity of the substrate 202, a material with a lower nucleation density than the nucleation surface is selected as the non-nucleation surface. On the floor of each of the respective concavities 201a, 201b..., nucleation surfaces 203a, 203b... are each respectively provided.

When crystal growth treatment is applied to the substrate having a plurality of concavities provided thereon by such working according to, for example, a gas phase method such as CVD method or a liquid phase method, etc., a single crystal 204a, with a contact surface with the substrate of approximately regular hexagonal shape, will grow as shown in Fig. 7B. The single crystal 204a can be also grown by controlling the growth time until the adjacent crystals contact each other (see Fig. 7B).

The base material for the substrate may be any material suitable for subsequent treatments, such as Si wafer, quartz glass, ceramics, etc.

As the material of the single crystal to be grown, in addition to Si, Ge, GaAs, InP, etc., other crystal material may be employed.

As the material for the nucleation surface, for example, a material with high nucleation density such as amorphous SiN, amorphous SiON, etc. may be employed.

Also, when single crystalline seeds formed by heat treatment are arranged as the origination points for crystal growth on the base material, for example, a material containing a dopant such as P, B, As, etc. preferably at 1 x 10²⁰ atoms/cm³, more preferably 7.5 x 10²⁰ atoms/cm³ may be also employed.

In the following, Examples in which a plurality of Si single crystals are formed on a substrate based on the present invention are shown.

### Example 1

(1) First, with the use of a Si (100) wafer substrate as the base material, a first amorphous silicon oxide film with a film thickness of about 100 nm (1000 Å) is formed by the thermal oxidation method. Next, by reduced pressure CVD using starting gases of SiH₂Cl₂ and NH₃, an amorphous silicon nitride film is deposited to 30 nm (300 Å) on the above silicon oxide film. Next, by a conventional resist process, the silicon nitride film is patterned to have areas of square shape 2 um square at hexagonal lattice points at intervals of 80 µm, and the first silicon oxide surface is exposed. Reactive ion etching is then applied to the silicon nitride film to remove surplus film and thus form the nucleation surfaces (see Fig. 5A).
   A second silicon oxide film is further deposited by conventional CVD to 700 nm (7000 Å) on the substrate having a number of nucleation surfaces comprising fine silicon nitride film areas at predetermined positions on the surface as described above. The second silicon oxide film is patterned by conventional resist processing so that regular octagonal portions of side length 30 µm are removed with the fine silicon nitride film areas at each centre to expose each nucleation surface etching treatment. Conventional RIE is then performed to remove surplus portions of the second silicon oxide film (see Fig. 6A).
(2) On the substrate, Si is deposited by a CVD method. The deposition conditions may be as follows.
   Gases used (flow rate ratio): SiH₂Cl₂/HCl/H₂ = 0.53/1.6/100.0 (slm)
   Substrate temperature and Pressure: 1000°C, 2.00x10⁴ Pa (150 Torr)
   Deposition time: 90 min.

As a result, with the centres of substantially all the nucleation surfaces arranged at lattice points as the crystal growth origination points, Si single crystals with a grain size of about 80 µm are grown, which contact the single crystals grown from the adjacent nucleation surfaces to form a grain boundary. Besides, the sizes of the voids formed at the corner portions are found to be 0.5 µm in diameter or less.

Further, when the upper portion of the Si single crystal is cut by RIE, and the sizes of the voids revealed after flattening are observed, the sizes of the voids are found to be also all 0.5 µm or less in diameter.

### Example 2

First, with the use of a Si (100) wafer substrate as the base material for the substrate, a silicon oxide film with a thickness of about 100 nm (1000 Å) is formed by thermal oxidation.

On the above silicon oxide film is deposited an amorphous silicon (hereinafter abbreviated as a-Si) film by reduced pressure CVD using SiH₄ under the growth conditions of a substrate temperature of 560°C and a pressure of 40Pa (0.3 Torr) to a thickness of 100 nm (1000Å). When the deposited film is examined by X-ray diffraction, it is confirmed to be completely amorphous. Then, phosphorus is doped into the a-Si film as an impurity at a concentration of 7.5 x 10²⁰ atoms/cm³ by thermal diffusion using POCl₃.

Next, by a conventional resist process, the a-Si film subjected to the doping (written as "a-Si (P) film") is patterned into square shapes 2 µm square at lattice points at intervals of 80 µm, and the surface of the silicon oxide film is exposed. Conventional RIE (reactive ion etching) is then performed surplus to remove a-Si film.

Further, the finely formed a-Si (P) films are annealed at a temperature of 950°C for 20 minutes in N₂ atmosphere. It would be sufficient, however, if the temperature were 800°C or higher. After annealing, examination by the X-ray diffraction method reveals that all of the above a-Si (P) film areas are formed into single crystal grains with a regular face orientation in the <111> direction as viewed from above the substrate (single crystalline Si (P) film). This phenomenon is also known in Y. Wada and S. Nishimatsu, J. Electrochem. Soc. 125, 1499 (1978) and others, and called "Abnormal grain growth".

On the substrate having a large number of nucleation surfaces comprised of single crystalline Si (P) films formed on predetermined positions on the surface, a second silicon oxide film is deposited to 700 nm (7000 Å) by a conventional CVD method. The silicon oxide film is patterned by a conventional resist process so that regular octagonal portions of side 30 µm are removed with a fine single crystalline Si (P) area film at each centre to expose as nucleation surface. RIE is then performed to remove any surplus portion of the second silicon oxide film.

On the substrate, Si is deposited by CVD. The deposition conditions are as follows.
Gases used (flow rate ratio): SiH₂Cl₂/HCl/H₂ = 0.53/1.7/100.0 (1/min)
Substrate temperature and Pressure: 1000°C. 2.00x10⁴ Pa (150 Torr)
Deposition time: 80 min.

As the result, fine single crystalline Si films are epitaxially grown while maintaining their crystallinity, whereby Si single crystals with a grain size of about 70 µm are grown, which contact the side faces of the second silicon oxide film to cover the surface of the second silicon oxide film. As a result of observation by an optical microscope, the sizes of the voids are found to be all 0.5 µm or less in diameter. When polishing is effected on the Si single crystals according to a selective polishing method, which effects etching of Si but no etching of silicon oxide, by placing a polishing cloth against the substrate surface while supplying an aqueous amine solution and rubbing the polishing cloth with the substrate surface, polishing was completed with the second silicon oxide film as an etch-stop. The substrate thus treated is again subjected to surface observation by an optical microscope, and the sizes of the voids is also found to be all 0.5 µm or less in diameter.

### Example 3

With the use of a quartz substrate as the base material, etching treatment is applied on the quartz substrate by use of conventional resist process and the RIE method so that circular concavities with a diameter of 80 µm and a depth of 500 nm (5000Å) are formed.

Next, a silicon nitride film is deposited to about 30 nm (300 Å) according to the reduced pressure CVD method by use of SiH₂Cl₂ and NH₃. Next, by use of conventional resist process and the RIE method, the silicon nitride film is subjected to an etching treatment so as to be arranged in square shapes 2 µm square at the centre of each circular concavity, thereby forming a substrate having a nucleation surface formed thereon.

On the substrate, Si is deposited according to the CVD method under the following conditions.
Gases (flow rate ratio): SiH₂Cl₂/HCl/H₂: 0.53/1.6/100 (ℓ/min.)
Substrate temperature and Pressure: 1000°C. 2.00x10⁴ Pa (150 Torr)
Deposition time: 90 min.

As a result, with substantially all the nucleation surfaces as the centres, Si crystal grains of a grain size of 80 µm are grown embedded in the circular concavities. When observed by an optical microscope, voids are observed in the vicinity of the side walls of the concavities, but their sizes are all 0.3 µm or less in diameter, and among them, there are also some concavities in which no voids are observable by an optical microscope.

Further, Si crystal grains are polished by use of conventional Si wafer polishing. Polishing is completed when the upper surface of the Si crystal grains became the same height as the upper surface of the quartz substrate, and again observation is made by an optical microscope. As the result, the sizes of the voids are found to be also all 0.3 µm or less in diameter.

### Example 4

First, by use of a Si (100) wafer as the base material, an amorphous silicon oxide film with a film thickness of 100 nm (1000 Å) is formed on its surface.

Next, a silicon nitride film is deposited to 30 nm (300 Å) according to the conventional reduced pressure CVD method by use of SiH₂Cl₂ and NH₃.

The silicon nitride film is subjected to a patterning treatment by use of conventional resist process so that the silicon nitride film is arranged in squares 2 µm square at hexagonal lattice points with an interval of 80 µm as the nucleation surfaces 502a, 502b..., with the remaining region of the amorphous silicon oxide film exposed to become the non-nucleation surface 501 (Fig.5A).

When the crystal growth treatment is applied under the same conditions as in Example 1, Si single crystal 503a with a grain size of 80 µm is found to grow with the nucleation surfaces arranged at hexagonal lattice points at each centre and contact Si single crystal 503b grown from the adjacent nucleation surface, thereby forming a grain boundary. The sizes of the voids 504 formed at the corner portions are found to be all 0.5 µm or less in diameter.

## Claims

1. A method of forming a crystalline film of semiconductor material on the surface of a substrate (501), which method comprises:
producing a multiplicity of crystal growth sites (502a-502k) at the surface of said substrate (501);
growing a single crystal (503a-503k) of said semiconductor material at each of said sites (502a-502k); and
continuing growth of each single crystal (503a-503k) at least until each comes into contact with those (503a-503k) growing adjacent thereto, thereby forming a crystalline film;
which method is characterised in that said producing of sites (502a-502k) is performed such that said sites (502a-502k) are regularly spaced and located at positions of 6-fold symmetry.

2. A method according to claim 1 wherein said semiconductor material is one of silicon, germanium, gallium arsenide or indium phosphide.

3. A method according to either preceding claim wherein each growth site (502a-502k) is formed of amorphous silicon nitride or amorphous silicon oxynitride.

4. A method according to claim 1 wherein each growth site (502a-502k) is of doped material, which material includes a dopant selected from phosphorus, boron or arsenic.

5. A method according to claim 4 wherein said doped material is of single crystal silicon including phosphorus dopant.

6. A method according to claim 1 wherein each of said growth sites (502a-502k), as produced, is provided upon a non-nucleation surface of said substrate (501).

7. A method according to claim 1 wherein each of said growth sites (103) as produced is provided embedded in or located upon a non-nucleation surface (102) of said substrate (101) at the foot of a respective concavity in the surface of said substrate (101).

8. A method according to claim 7 wherein each concavity is of n-gonal cross-section, where n is integer and not less than 5.

9. A method according to claim 8 wherein each concavity is of hexagonal cross-section.

10. A method according to claim 8 wherein each concavity is of octagonal cross-section.

11. A method according to claim 1 wherein the crystal growth sites produced are of amorphous material and growth of each single crystal is preceded by nucleation of said semiconductor material at each of said sites.

12. A method according to claim 1 wherein the crystal growth sites produced are single crystal seeds.

13. A method according to claim 12 wherein said seeds are produced by first forming areas of amorphous material and then annealing said amorphous material.

## Patentansprüche

1. Verfahren zur Herstellung eines kristallinen Films aus Halbleitermaterial auf der Oberfläche eines Substrates (501), umfassend:
Herstellung einer Vielzahl Kristallwachstumsstellen (502a bis 502k) auf der Oberfläche des Substrates (501);
Ziehen eines Einkristalls (503a bis 503k) aus dem Halbleitermaterial an jeder der genannten Stellen (502a bis 502k); und
Fortsetzen der Züchtung jedes Einkristalls (503a bis 503k) wenigstens solange, bis jeder diejenigen (503a bis 503k), die in Nachbarschaft zu ihm wachsen, berührt, wobei ein kristalliner Film gebildet wird;
wobei das Verfahren dadurch gekennzeichnet ist, daß die Herstellung der Stellen (502a bis 502k) so durchgeführt wird, daß die Stellen (502a bis 502k) in regelmäßigen Abständen und auf Positionen mit 6-zähliger Symmetrie angeordnet sind.

2. Verfahren nach Anspruch 1, worin das Halbleitermaterial ausgewählt ist aus Silicium, Germanium, Galliumarsenid oder Indiumphosphid.

3. Verfahren nach einem der vorstehenden Ansprüche, worin jede Wachstumsstelle (502a bis 502k) aus amorphem Siliciumnitrid oder amorphem Siliciumoxynitrid gebildet wird.

4. Verfahren nach Anspruch 1, worin jede Wachstumsstelle (502a bis 502k) aus dotiertem Material besteht, wobei das Material ein Dotierungsmittel einschließt, das ausgewählt ist aus Phosphor, Bor oder Arsen.

5. Verfahren nach Anspruch 4, worin das dotierte Material aus einkristallinem Silicium besteht, das das Dotierungsmittel Phosphor einschließt.

6. Verfahren nach Anspruch 1, worin jede der so hergestellten Wachstumsstellen (502a bis 502k) auf der nicht-keimbildenden Oberfläche des Substrates (501) bereitgestellt wird.

7. Verfahren nach Anspruch 1, worin jede der genannten, so hergestellten Wachstumsstellen (103) eingebettet in oder angeordnet auf einer nicht-keimbildenden Oberfläche (102) des Substrates (101) am Boden einer entsprechenden Einbuchtung in der Oberfläche des Substrates (101) bereitgestellt wird.

8. Verfahren nach Anspruch 7, worin jede Einbuchtung einen n-eckigen Querschnitt besitzt, wobei n eine ganze Zahl und nicht kleiner als 5 ist.

9. Verfahren nach Anspruch 8, worin jede Einbuchtung einen hexagonalen Querschnitt besitzt.

10. Verfahren nach Anspruch 8, worin jede Einbuchtung einen oktagonalen Querschnitt besitzt.

11. Verfahren nach Anspruch 1, worin die hergestellten Kristallwachstumsstellen aus amorphem Material bestehen und dem Ziehen eines jeden Einkristalls Keimbildung mit dem genannten Halbleitermaterial an jeder der genannten Stellen vorausgeht.

12. Verfahren nach Anspruch 1, worin die hergestellten Kristallwachstumsstellen Einkristallkeime sind.

13. Verfahren nach Anspruch 12, worin die Keime hergestellt werden, indem zuerst Gebiete aus amorphem Material gebildet werden und dann das amorphe Material getempert wird.

## Revendications

1. Procédé pour former un film cristallin de matériau semiconducteur sur la surface d'un substrat (501), lequel procédé comprend:
la production d'une multiplicité de sites de croissance cristalline (502a-502k) à la surface dudit substrat (501);
la croissance d'un monocristal (503a-503k) dudit matériau semiconducteur en chacun desdits sites (502a-502k); et
la poursuite de la croissance de chaque monocristal (503a-503k) au moins jusqu'à ce que chacun d'entre eux vienne au contact de ceux (503a-503k) qui croissent à leur voisinage immédiat, afin de former ainsi un film cristallin;
lequel procédé est caractérisé en ce que ladite production de sites (502a-502k) est effectuée de manière à ce que lesdits sites (502a-502k) soient régulièrement espacés et situés en des positions à symétrie sextuple.

2. Procédé selon la revendication 1, dans lequel ledit matériau semiconducteur est choisi parmi le silicium, le germanium, l'arséniure de gallium ou le phosphure d'indium.

3. Procédé selon l'une quelconque des revendications précédentes, caractérisé en ce que chaque site de croissance (502a-502k) est formé de nitrure de silicium amorphe ou d'oxynitrure de silicium amorphe.

4. Procédé selon la revendication 1, dans lequel chaque site de croissance (502a-502k) est constitué de matériau dopé, lequel matériau inclut un dopant sélectionné parmi le phosphore, le bore ou l'arsenic.

5. Procédé selon la revendication 4, dans lequel ledit matériau dopé est constitué de silicium monocristallin comportant du phosphore comme dopant.

6. Procédé selon la revendication 1, dans lequel chacun desdits sites de croissance (502a-502k), tel qu'il est produit, est réalisé sur une surface dudit substrat exempte de nucléation (501).

7. Procédé selon la revendication 1, dans lequel chacun desdits sites de croissance (103), tel qu'il est produit, est réalisé en étant noyé dans, ou situé sur, une surface exempte de nucléation (102) dudit substrat (101) à la base d'une concavité respective ménagée dans la surface dudit substrat (101).

8. Procédé selon la revendication 7, dans lequel chaque cavité est de section droite n-gonale, où n est un entier non inférieur à 5.

9. Procédé selon la revendication 8, dans lequel chaque concavité est de section droite hexagonale.

10. Procédé selon la revendication 8, dans lequel chaque concavité est de section droite octogonale.

11. Procédé selon la revendication 1, dans lequel les sites de croissance cristalline produits sont constitués d'un matériau amorphe et dans lequel la croissance de chaque monocristal est précédée d'une nucléation dudit matériau semiconducteur en chacun desdits sites.

12. Procédé selon la revendication 1, dans lequel les sites de croissance cristalline produits sont des germes monocristallins.

13. Procédé selon la revendication 12, dans lequel lesdits germes sont produits en formant tout d'abord des zones de matériau amorphe puis en recuisant ledit matériau amorphe.
